# EUROPÄISCHE PATENTSCHRIFT

(11) **EP 0 992 065 B1**
(45) Veröffentlichungstag und Bekanntmachung des Hinweises auf die Patenterteilung: **22.11.2006**
(21) Anmeldenummer: 99910583.6
(22) Anmeldetag: 07.04.1999
(51) Int. Cl.: H01L 23/498, G06K 19/077

(54) **FOLIE ALS TRÄGER VON INTEGRIERTEN SCHALTUNGEN**
FILM USED AS A SUBSTRATE FOR INTEGRATED CIRCUITS
FILM UTILISE COMME SUBSTRAT DE CIRCUITS INTEGRES

(30) Priorität: 09.04.1998 DE 19816066
(43) Veröffentlichungstag der Anmeldung: 12.04.2000
(73) Patentinhaber: Koninklijke Philips Electronics N.V., 5621 BA Eindhoven (NL); W.C. Heraeus GmbH, 63450 Hanau (DE); Nedcard B.V., 6545 CE Nijmegen (NL); Philips Intellectual Property & Standards GmbH, 20099 Hamburg (DE)
(72) Erfinder: SAUER, Veronika, NL-5656 AA Eindhoven (NL); SLAGER, Ben, NL-5656 AA Eindhoven (NL); LACH, Friedrich, NL-5656 AA Eindhoven (NL); BAUER, Alfred, NL-5656 AA Eindhoven (NL); HARTMANN, Horst, NL-5656 AA Eindhoven (NL); KOLODZEI, Günther, NL-5656 AA Eindhoven (NL)
(74) Vertreter: Peters, Carl Heinrich
(86) Internationale Anmeldenummer: PCT/IB1999/000591
(87) Internationale Veröffentlichungsnummer: WO 1999/053545

(56) Entgegenhaltungen:
- EP-A- 0 197 847
- EP-A- 0 599 194

## Beschreibung

Die Erfindung betrifft eine Folie in Form eines langgestreckten Filmstreifens mit Randlochung und Leiterbahnen als Träger einer Vielzahl von integrierten Schaltungen gemäß dem Oberbegriff des unabhängigen Anspruchs 1.

Derartige Folien sind allgemein bekannt und dienen dazu, Chip-Karten mit möglichst wenig Aufwand und damit preisgünstig herzustellen. Durch die Ausbildung der Folie als langgestreckter Filmstreifen mit einer periodischen Anordnung desselben Leiterbahnmusters können die integrierten Schaltungen mit Hilfe eines Automaten aufgebracht und kontaktiert werden. Anschließend werden die integrierten Schaltungen mit dem umgebenden Leiterbahnmuster als ein Stück aus dem Filmstreifen ausgestanzt und in die entsprechenden Teile der Chip-Karten eingesetzt. Das Leiterbahnmuster dient dann gleichzeitig zur Kontaktierung der integrierten Schaltung von außerhalb der Chip-Karte.

In neuerer Zeit sind integrierte Schaltungen bekannt geworden, die nicht nur über Kontakte betreibbar sind, sondern auch kontaktlos, nämlich induktiv über eine Spule. Diese Spule wird gesondert in die Chip-Karte eingebaut und mit besonderen Anschlüssen der integrierten Schaltung verbunden. Diese Verbindung kann dadurch erfolgen, daß die Enden der Spule direkt mit entsprechenden Anschlüssen der integrierten Schaltung verbunden werden. Eine solche Art der Verbindung hat jedoch verschiedene Nachteile, insbesondere wird die integrierte Schaltung dabei mechanisch stark belastet und kann dadurch beschädigt werden.

Eine andere Möglichkeit besteht darin, auf der Kunststoffolie eine weitere Metallfolie mit entsprechendem Leiterbahnmuster aufzubringen, so daß die Kunststoffolie beidseitig mit einem Leiterbahnmuster bedeckt ist, wobei ein Leiterbahnmuster nur zur Herstellung einer Verbindung zwischen der Spule und der integrierten Schaltung dient. Dabei hat sich jedoch herausgestellt, daß eine solche Kunststoffolie mit beidseitigen Leiterbahnen sehr viel steifer ist als eine solche Folie mit Leiterbahnen auf nur einer Seite und dadurch in den üblichen Automaten nicht ohne weiteres verarbeitet werden kann bzw. zu Störungen bei der Verarbeitung führt.

Aufgabe der Erfindung ist es, eine Folie in Form eines langgestreckten Filmstreifens mit Randlochung und Leiterbahnen der eingangs genannten Art so auszubilden, daß er für die Aufnahme von integrierten Schaltungen geeignet ist, die sowohl über Kontakte als auch kontaktlos betrieben werden können, wobei der Filmstreifen möglichst flexibel bleibt.

Diese Aufgabe wird bei einer Folie der gattungsgemäßen Art erfindungsgemäß durch die kennzeichnenden Merkmale des unabhängigen Anspruchs 1 gelöst.

Durch die Verringerung des Querschnitts in beiden Leiterbahnen ist der Filmstreifen in Längsrichtung weiterhin so flexibel, daß er in den vorhandenen Automaten ohne wesentliche Störung weiter benutzt werden kann. Dabei ist zu berücksichtigen, daß die Größe und Form der Leiterbahnen im Kontaktfeld, über die die integrierte Schaltung mittels Kontakten angesteuert wird, weitgehend festgelegt ist. Außerdem muß bei einem Leiterbahnmuster, das aus einer Metallfolie ausgestanzt und dann auf eine Kunststofffolie aufgeklebt wird, jeder Teil der Leiterbahn mit den übrigen Teilen verbunden sein. Dies gilt auch im Hinblick auf eine anschließende Oberflächenveredelung der Leiterbahnen. Durch entsprechende Formgebung kann jedoch dafür gesorgt werden, daß sich Verbindungen im Leiterbahnmuster im wesentlichen quer zur Längsrichtung des Filmstreifens erstrecken, so daß solche Unterbrechungen im Leiterbahnmuster vorgesehen werden können, die den Gesamtquerschnitt beider Metallfolien senkrecht zur Längsrichtung des Filmstreifens immer wieder in kurzen Abständen verringern.

Um beim Aufkleben der Metallfolie mit dem ausgestanzten Leiterbahnmuster eine definierte Position auf der Kunststoffolie zu erreichen, weist sowohl diese als auch die Metallfolie Randlochungen auf, die zur Ausrichtung verwendet werden. Der Randstreifen der beiden Metallfolien mit den Randlochungen führt jedoch zu einer Versteifung in Längsrichtung des Filmstreifens. Um diese Steifigkeit zu verringern, ist es nach einer Ausgestaltung der Erfindung zweckmäßig, daß in beiden Metallfolien an übereinstimmenden Orten im Bereich der Randlochung eine sich über mehrere aufeinanderfolgende Randlochungen erstreckende Öffnung vorhanden ist. Es hat sich herausgestellt, daß eine Ausrichtung an nur einigen Randlochungen, insbesondere an je einer Randlochung für jedes einer integrierten Schaltung zugeordneten Leiterbahnmusters ausreicht.

Wird in einer Abwandlung der Vorgehensweise bei dieser Ausrichtung jedoch eine Vorgehensweise bevorzugt, bei der jedes einzelne Randloch benutzt wird, kann es gemäß einer entsprechend vorgenommenen Ausgestaltung der erfindungsgemäßen Folie vorteilhaft sein, daß in wenigstens einer Metallfolie im Bereich der Randlochung wenigstens eine sich zwischen je zwei aufeinanderfolgenden Randlochungen erstreckende, die Randlochungen nicht berührende Öffnung vorhanden ist. Dabei kann es genügen, wenn nur eine der beiden Metallfolien im Bereich der Randlochungen die genannten Öffnungen aufweist. Eine besonders gute Flexibilität wird jedoch dadurch erreicht, daß in beiden Metallfolien an übereinstimmenden Orten im Bereich der Randlochung sich zwischen je zwei aufeinanderfolgenden Randlochungen erstreckende, die Randlochungen nicht berührende Öffnungen vorhanden sind.

Diese Ausbildungen der erfindungsgemäßen Folie zeigen insbesondere bei der Herstellung von Chip-Karten in dem Fall Vorteile, wenn sämtliche Randlöcher zur optischen Zentrierung der Folie bei deren Montage in der Chip-Karte verwendet werden. Dann ist es vorteilhaft, wenn alle Randlöcher gleichmäßig durch Teile wenigstens je einer der Metallfolien berandet sind. Werden dagegen zur optischen Zentrierung der Folie sowohl Randlöcher mit einer Berandung aus Metallfolie als auch solche mit einer Berandung lediglich aus Kunststoffolie verwendet, muß bei einer automatischen Zentrierung die unterschiedliche optische Durchlässigkeit der Randlöcher und ihrer Berandungen berücksichtigt werden. Durch die letztgenannte Ausgestaltung der erfindungsgemäßen Folie werden hier besonders einfach zu beherrschende Verhältnisse geschaffen.

Ausführungsbeispiele der Erfindung werden nachfolgend anhand der Zeichnung erläutert. Es zeigen:
Fig. 1 ein Leiterbahnmuster für den Anschluß der Spule,
Fig. 2 ein Leiterbahnmuster für das Kontaktfeld,
Fig. 3 ein Muster von Öffnungen in der Kunststoffolie,
Fig. 4 die Kunststoffolie mit aufgeklebten Leiterbahnen, sowie für ein zweites Ausführungsbeispiel:
Fig. 5 ein Leiterbahnmuster für den Anschluß der Spule,
Fig. 6 ein Leiterbahnmuster für das Kontaktfeld,
Fig. 7 ein Muster von Öffnungen in der Kunststoffolie,
Fig. 8 die Kunststoffolie mit aufgeklebten Leiterbahnen.

Dabei sind übereinstimmende Elemente in allen Figuren mit identischen Bezugszeichen versehen.

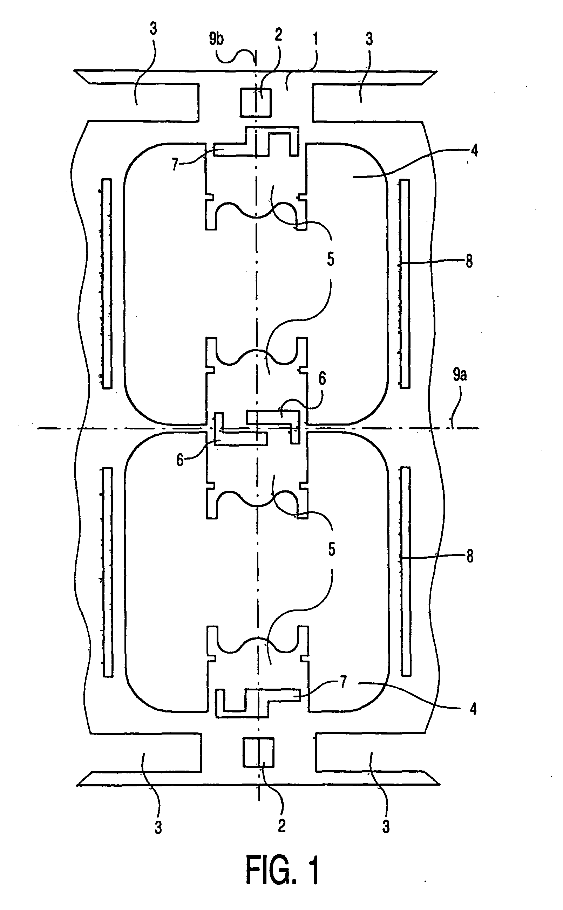

Fig. 1 zeigt eine Metallfolie 1 mit einem Leiterbahnmuster für zwei integrierte Schaltungen nebeneinander. Dieses Leiterbahnmuster wiederholt sich periodisch auf beiden Seiten neben dem dargestellten Leiterbahnmuster.

Das dargestellte Muster ist rotationssymmetrisch zu dem Schnittpunkt der beiden Achsen 9a und 9b. Auf beiden Seiten der Achse 9a sind in der Metallfolie 1 Randlöcher 2 vorhanden, die beim Aufkleben in Deckung mit entsprechenden Randlöchern der Kunststoffolie zur Deckung gebracht werden. Zu beiden Seiten der Randlöcher 2 sind Öffnungen 3 vorgesehen, in denen weitere Randlöcher der Kunststoffolie liegen, wie später gezeigt wird. Durch diese Öffnungen 3 wird der Querschnitt der Metallfolie 1 parallel zur Achse 9b wesentlich verringert, so daß nach dem Aufbringen der Folie 1 auf die Kunststoffolie die Flexibilität in Längsrichtung des Filmstreifens, d.h. in Richtung der Achse 9a, relativ groß bleibt.

Zwischen den Randlochungen 2 und Öffnungen 3 oben und unten sind, durch Stege in der Metallfolie 1 begrenzt, Öffnungen 4 vorgesehen, die etwas größer sind als der Teil, der nach dem Aufbringen der Metallfolien auf die Kunststoffolien und dem Einsetzen und Kontaktieren von integrierten Schaltungen ausgestanzt wird zum Einsetzen in eine Chip-Karte.

In die Öffnungen 4 ragen Vorsprünge 5, die die Kontaktflächen sowohl für den Anschluß der beiden Enden einer Spule als auch der Bonddrähte der integrierten Schaltung nach dem Einsetzen bilden. Durch die Öffnungen 6 und 7 in der Metallfolie 1 hängen die Vorsprünge 5 nur über schmale Stege mit dem übrigen Bereich der Metallfolie 1 zusammen, um einerseits nach dem Ausstanzen die Verbindung der Vorsprünge 5 zu anderen Teilen der Metallfolie 1 sicher zu unterbrechen und um andererseits auch die Flexibilität in Längsrichtung parallel zur Achse 9a zu verbessern.

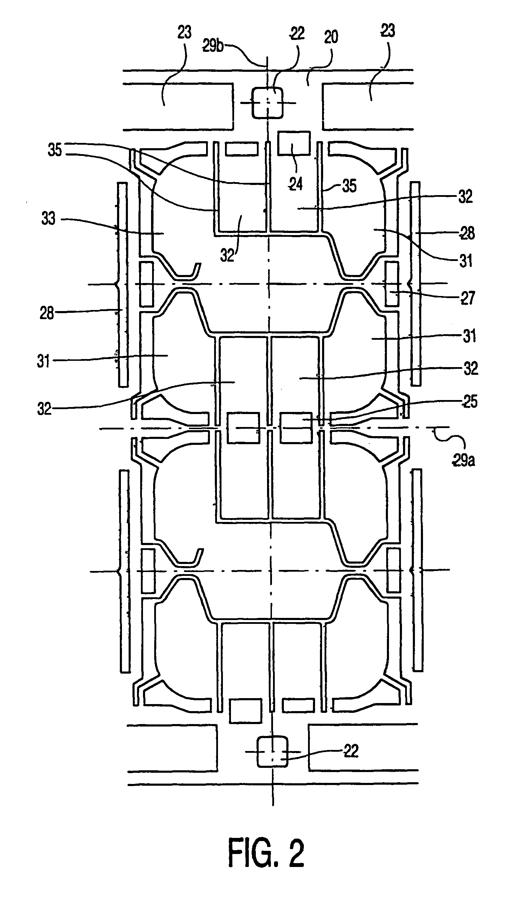

Der Abstand zwischen den Öffnungen 4 ist durch die Abstände der Randlochungen in der Kunststoffolie und die Größe des Kontaktfeldes, das näher in der Fig. 2 dargestellt ist, gegeben. Um den Querschnitt der Metallfolie 1 zwischen den in Längsrichtung aufeinanderfolgenden Öffnungen 4 zumindest in kurzen Abständen zu verringern, ist eine Öffnung 8 vorgesehen, durch die die Flexibilität in Längsrichung parallel zur Achse 9a weiter verbessert wird.

In Fig. 2 ist das Leiterbahnmuster für die Kontaktfeldseite dargestellt. Dieses Leiterbahnmuster wird durch eine Metallfolie 20 gebildet, die entsprechend ausgestanzt ist. Das dargestellte Muster wiederholt sich auch hier periodisch zu beiden Seiten des dargestellten Musters in Richtung der Achse 29a.

Dieses Leiterbahnmuster weist wieder zu beiden Seiten Randlochungen 22 auf, neben denen zu beiden Seiten in Längsrichtung größere Öffnungen 23 vorhanden sind, um die Flexibilität zu verbessern. Die Randlochungen 22 und Öffnungen 23 entsprechen denen im Leiterbahnmuster nach Fig. 1.

Dazwischen liegen wieder, entsprechend dem Leiterbahnmuster in Fig. 1, zwei gleiche Leiterbahnmuster für zwei integrierte Schaltungen. Dieses Leiterbahnmuster enthält im wesentlichen Kontaktflächen 31, 32 und 33, die durch schmale Unterbrechungen 35 voneinander getrennt sind. Sie hängen nur im Bereich der Ränder und im Bereich der Mittelachse 29a über schmale Stege zusammen. Diese Stege werden bei dem bereits erwähnten Ausstanzen nach dem Aufbringen der integrierten Schaltungen durchtrennt. Die Form der einzelnen Kontaktflächen 31, 32 und 33 ist vorgegeben.

Ferner sind Öffnungen 24 und 25 vorhanden, die den Querschnitt parallel zur Achse 29b verringern.

Auch hier ist zwischen in Längsrichtung benachbarten Leiterbahnmustern eine Öffnung 28 vorgesehen, die die Flexibilität in Längsrichtung parallel zur Achse 29a erhöht.

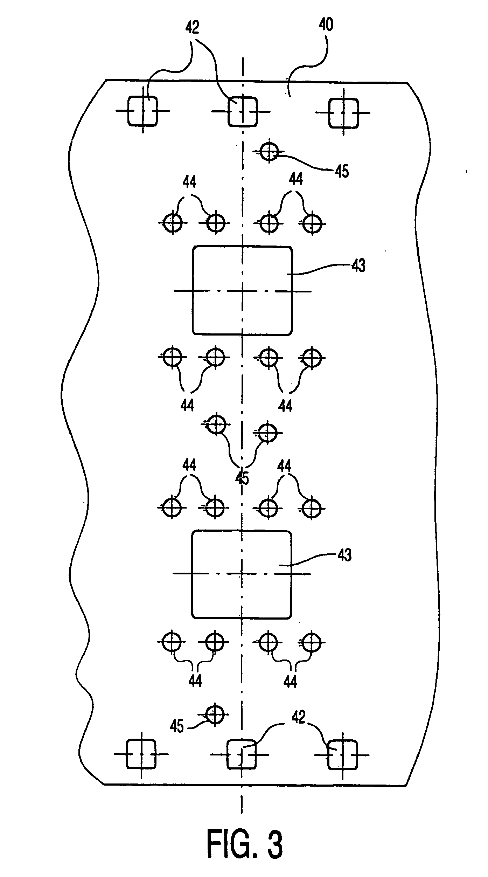

Fig. 3 zeigt einen Ausschnitt aus einer Kunststoffolie 40, auf die die in Fig. 1 und 2 dargestellten Metallfolien aufgeklebt werden. Die Kunststoffolie 40 hat die Form eines Filmstreifens und weist Randlochungen 42 auf, die sich regelmäßig in einem Abstand kleiner als die Periode der Leiterbahnmuster wiederholen. Zwischen den Rändern sind zwei Durchbrüche 43 dargestellt, die nach dem Aufkleben der Metallfolie 20 durch die Leiterbahnfläche 33 abgedeckt wird und in die die integrierte Schaltung auf diese Leiterbahnfläche aufgebracht wird. Ferner sind zu beiden Seiten der Durchbrüche 43 eine Reihe von Löchern 44 vorgesehen, die nach dem Aufkleben der Metallfolie 20 durch die Leiterbahnflächen 31 bzw. 32 bzw. 33 abgedeckt werden und durch die nach dem Einsetzen der integrierten Schaltung deren Kontakte mit diesen Leiterbahnteilen durch Bonddrähte verbunden werden. Ferner sind Löcher 45 vorgesehen, die durch die entsprechenden Teile der Vorsprünge 5 der Metallfolie 1 abgedeckt werden.

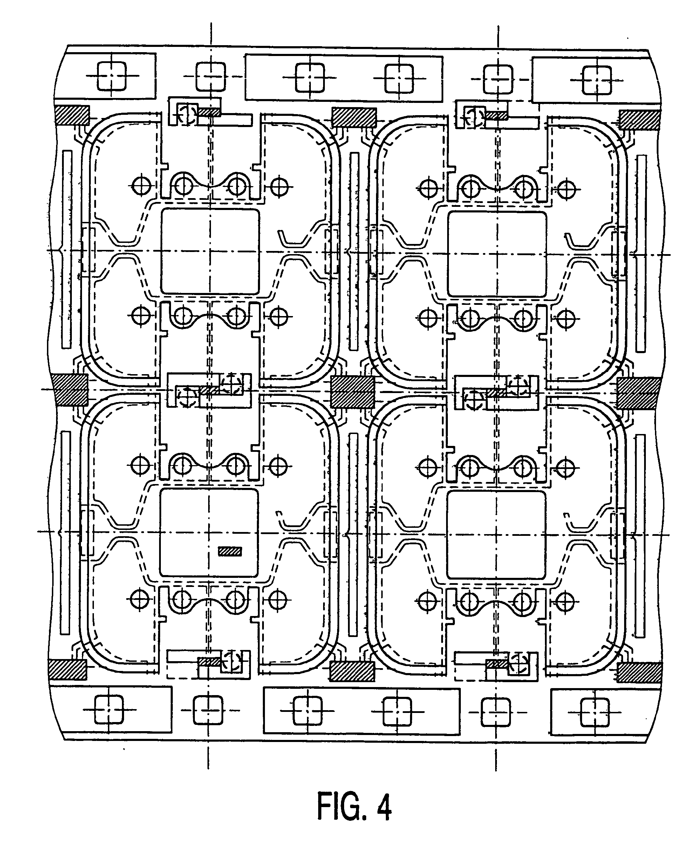

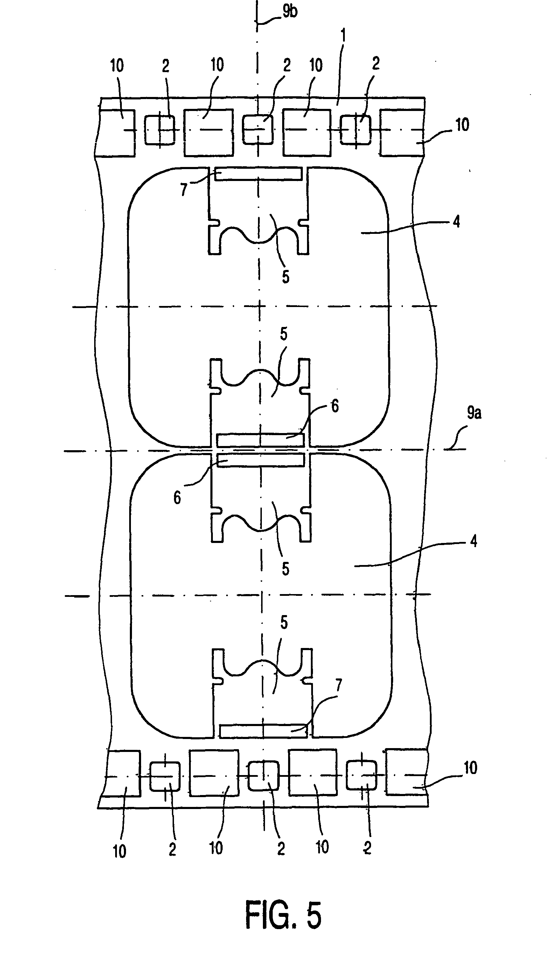

Die Fig. 4 zeigt einen Abschnitt eines Filmstreifens, bei dem auf der in Fig. 3 dargestellten Kunststoffolie die in den Fig. 1 und 2 dargestellten Metallfolien mit den entsprechenden Leiterbahnmustern aufgeklebt sind. Dargestellt ist die Draufsicht auf das Leiterbahnmuster der Metallfolie 1. Der Deutlichkeit halber sind hier zwei benachbarte Leiterbahnmuster für je zwei integrierte Schaltungen dargestellt. Es ist zu erkennen, daß die Öffnungen 3 bzw. 23 in den Metallfolien 1 bzw. 20 sich über zwei Randlochungen in der Kunststoffolie 40 der Fig. 3 erstrecken. Auch die Lage der Öffnungen 43 in Fig. 3 über der Leiterfläche 33 in Fig. 2 sowie die Lage der Löcher 44 in Fig. 3 über den entsprechenden Leiterflächen 31, 32 und 33 in Fig. 2, die in Fig. 4 gestrichelt dargestellt sind, ist zu erkennen. Ferner ist außerhalb dieser gestrichelt dargestellten Leiterbahnflächen eine dünne Linie dargestellt, die die Stanzlinie darstellt.
Das in den Fig. 5 bis 8 dargestellte, zweite Ausführungsbeispiel unterscheidet sich vom vorstehend beschriebenen aus den Fig. 1 bis 4 nur in einigen Konstruktionsmerkmalen, auf die im folgenden eingegangen werden soll. In ihren übrigen Merkmalen stimmen die Ausführungsbeispiele überein.

Das in Fig. 5 dargestellte Leiterbahnmuster des zweiten Ausführungsbeispiels unterscheidet sich von demjenigen in erster Linie dadurch, daß hier anstelle der dortigen Öffnungen 3 jetzt Öffnungen 10 treten, die sich zwischen je zwei aufeinanderfolgenden Randlochungen 2 erstrecken, diese jedoch nicht berühren, so daß jedes der Randlöcher 2 vollständig von Metallfolie umgeben ist. Bei einer optischen Zentrierung weisen somit alle Randlöcher 2 eine übereinstimmende Struktur auf. Durch die Öffnungen 10 wird der Querschnitt der Metallfolie 1 in diesem Ausführungsbeispiel parallel zur Achse 9b vergleichbar zum erstbeschriebenen Ausführungsbeispiel wesentlich verringert.

Auch für die Öffnungen 6, 7 wurde im zweiten Ausführungsbeispiel eine veränderte Kontur gewählt, die jedoch grundsätzlich keine veränderten Auswirkungen auf die Flexibilität der erfindungsgemäßen Folie hat.

Außerdem fehlen in der Darstellung der Fig. 5 die aus Fig. 1 ersichtlichen Öffnungen 8. Diese können jedoch ebensogut auch für das zweite Ausführungsbeispiel vorgesehen sein.

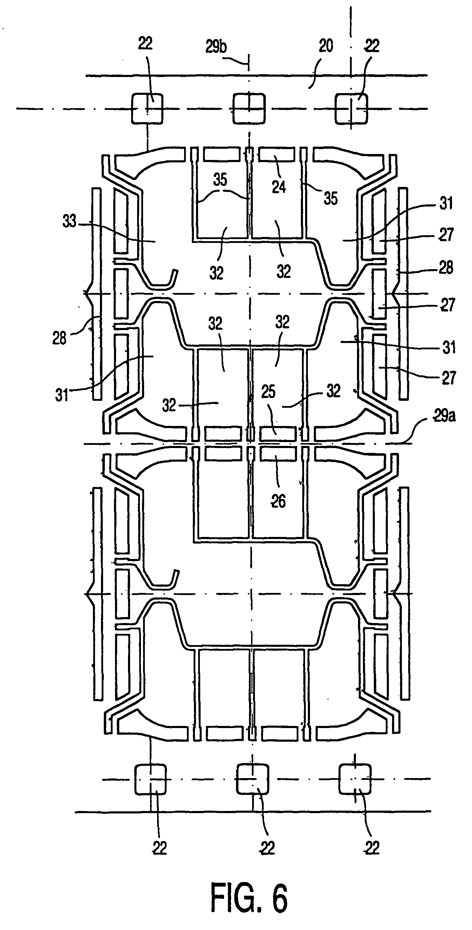

Fig. 6 zeigt das Leiterbahnmuster für die Kontaktfeldseite des zweiten Ausführungsbeispiels. Hier sind zwischen den Randlochungen 22 keine Öffnungen vorgesehen. Wahlweise können jedoch auch hier Öffnungen vorgesehen sein, die vorzugsweise in der fertigen Folie mit den Öffnungen 10 im Leiterbahnmuster nach Fig. 5 deckungsgleich angeordnet sind. In jedem Fall weisen auch hier alle Randlochungen 22 eine gleichmäßige Berandung aus Metallfolie auf.

Im zweiten Ausführungsbeispiel sind die Kontaktflächen 31, 32, 33 nach einer vom ersten Ausführungsbeispiel unterschiedlichen, insbesondere in Frankreich benutzten Norm gestaltet. Dabei sind insbesondere die Kontaktflächen 31 und 33 schmaler ausgeführt. Um die ihnen benachbarten Teile der Metallfolie 20 trotzdem flexibel zu erhalten, sind in Fig. 6 zusätzlich zu der in Fig. 2 einzigen Öffnung 27 in Höhe des Zentrums des Kontaktfeldes aus den Kontaktflächen 31, 32, 33 in Fig. 6 nun drei Öffnungen 27 zwischen der Öffnung 28 und den Kontaktflächen 31 bzw. 33 parallel zur Achse 29b angeordnet. Die Achse 29b liegt bei der zusammengefügten, erfindungsgemäßen Folie deckungsgleich mit der Achse 9b in Fig. 5.

Im übrigen wurden auch die Konturen der Öffnungen 24 und 25 geringfügig abgewandelt. Anstelle der bisherigen Öffnungen 25 in Fig. 2 treten nun zwei symmetrisch zur Achse 29a angeordnete Öffnungen 25, 26.

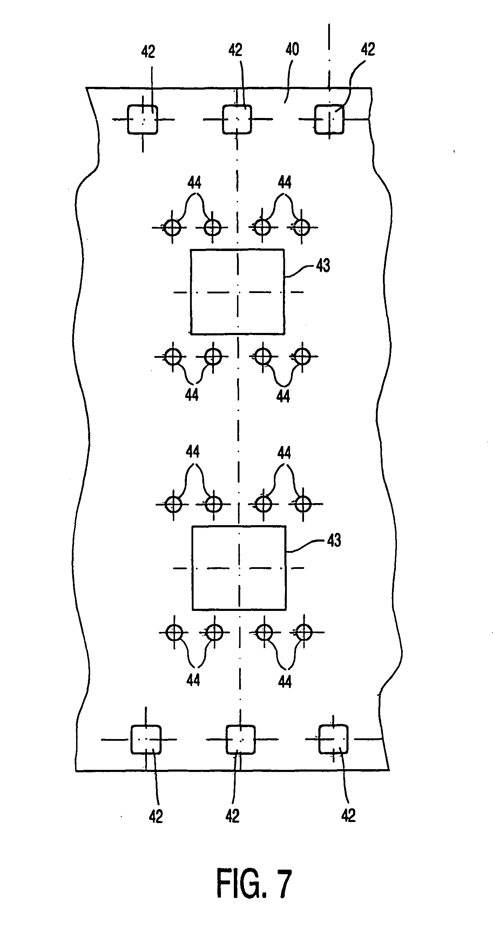

Die Kunststoffolie 40 des zweiten Ausführungsbeispiels gemäß Fig. 7 unterscheidet sich von der Darstellung der Kunststoffolie 40 gemäß Fig. 3 lediglich durch das Fehlen der dortigen Löcher 45. Wie bereits im ersten Ausführungsbeispiel die Öffnungen 3 bzw. 23 sind auch im zweiten Ausführungsbeispiel die den Randlöchern gegenüber größeren Öffnungen 10 in der Kunststoffolie 40 nicht vorhanden.

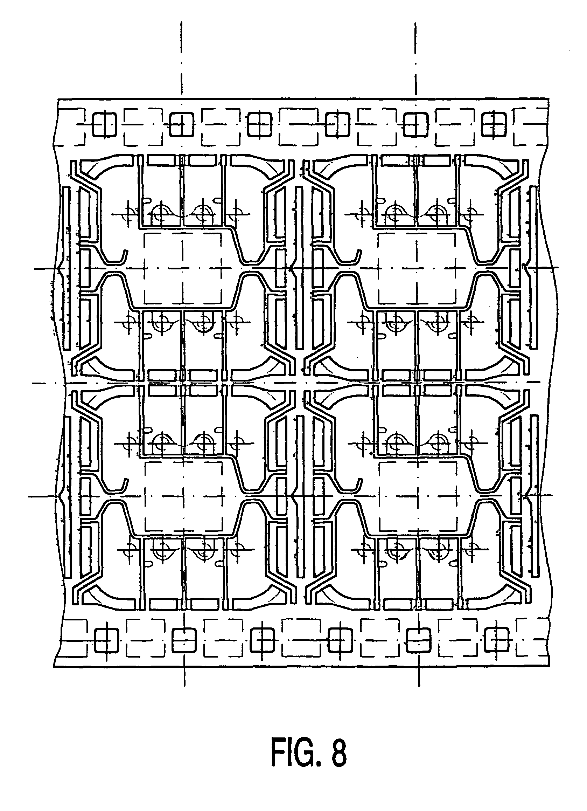

Fig. 8 zeigt einen Abschnitt eines Filmstreifens, bei dem auf der in Fig. 7 dargestellten Kunststoffolie 40 die in den Fig. 5 und 6 dargestellten Metallfolien 1 und 20 mit den entsprechenden Leiterbahnmustern aufgeklebt sind. Dargestellt ist für das zweite Ausführungsbeispiel in Fig. 8 die Draufsicht auf das Leiterbahnmuster der Metallfolie 20, wobei wieder der Deutlichkeit halber zwei benachbarte Leiterbahnmuster für je zwei integrierte Schaltungen dargestellt sind. Die Leiterbahnmuster der Metallfolie 1 und die Konturen der Kunststoffolie 40 sind dort, wo sie durch die darüberliegenden Folien, insbesondere die Metallfolie 20, abgedeckt werden, gestrichelt dargestellt.

## Patentansprüche

1. Folie in Form eines langgestreckten Filmstreifens (1, 20, 40) mit Randlochung und Leiterbahnen als Träger einer Vielzahl von integrierten Schaltungen zum Einbau vorzugsweise in Chip-Karten, wobei die Leiterbahnen aus einer Metallfolie (1; 20) gestanzt und auf eine mit Lochungen bzw. Durchbrüchen versehene Kunststoffolie (40) aufgeklebt sind,
**dadurch gekennzeichnet, daß** auf beiden Seiten der Kunststoffolie (40) je eine Metallfolie (1, 20) mit unterschiedlichen Leiterbahnmustern aufgeklebt ist und daß die Metallfolien (1; 20) auf beiden Seiten zusätzlich zu den zur Herstellung leitender Verbindungen durch das vorgegebene Leiterbahnmuster vorgenommenen Unterbrechungen weitere Unterbrechungen (3, 8, 10, 23, 24, 25, 26, 27, 28) aufweisen, um in Längsrichtung des Folienstreifens in im Vergleich zur Ausdehnung des Leiterbahnmusters kurzen Abständen den Gesamtquerschnitt beider Metallfolien (1, 20) senkrecht zur Längsrichtung des Filmstreifens in einem für dessen Flexibilität wesentlichen Maß zu verringern.

2. Folie nach Anspruch 1, wobei die Kunststoffolie (40) in regelmäßigen Abständen eine Randlochung (42) aufweist, **dadurch gekennzeichnet, daß** in beiden Metallfolien (1, 20) an übereinstimmenden Orten im Bereich der Randlochung (42)-eine sich über mehrere aufeinanderfolgende Randlochungen (42) erstreckende Öffnung (3, 23) vorhanden ist.

3. Folie nach Anspruch 1, wobei die Kunststoffolie (40) in regelmäßigen Abständen eine Randlochung (2, 22, 42) aufweist, **dadurch gekennzeichnet, daß** in wenigstens einer Metallfolie (1) im Bereich der Randlochung (2, 22, 42) wenigstens eine sich zwischen je zwei aufeinanderfolgenden Randlochungen (2, 22, 42) erstreckende, die Randlochungen (2, 22, 42) nicht berührende Öffnung (10) vorhanden ist.

4. Folie nach Anspruch 3, **dadurch gekennzeichnet, daß** in beiden Metallfolien (1, 20) an übereinstimmenden Orten im Bereich der Randlochung (2, 22, 42) sich zwischen je zwei aufeinanderfolgenden Randlochungen (2, 22, 42) erstreckende, die Randlochungen (2, 22, 42) nicht berührende Öffnungen (10) vorhanden sind.

## Claims

1. A foil in the form of an elongated film strip (1, 20, 40) with edge perforations and conductor tracks which serves as a carrier for a plurality of integrated circuits to be incorporated preferably in chip cards, the conductor tracks being cut out from a metal foil (1; 20) and glued onto a synthetic foil (40) provided with holes or openings, **characterized in that** a respective metal foil (1, 20) with different conductor track patterns is glued onto each side of the synthetic foil (40), and that the metal foils (1; 20) have on both sides further openings (3, 8, 10, 23, 24, 25, 26, 27, 28) in addition to the openings provided for establishing conductive connections by the specified conductor track pattern, in order to reduce in longitudinal direction of the film strip, at short distances compared to the elongation of the conductor track pattern, the total cross-section of the two metal foils (1, 20) perpendicularly to the longitudinal direction of the film strip to a degree that is essential to the flexibility of the film strip.

2. A foil as claimed in claim 1, the synthetic foil (40) being provided with edge perforations (42) at regular intervals, **characterized in that** both metal foils (1, 20) are provided, at corresponding locations at the area of the edge perforations (42), with an opening (3, 23) which extends over a plurality of successive edge perforations (42).

3. A foil as claimed in claim 1 wherein the synthetic foil (40) is provided with edge perforations (2, 22, 42) at regular intervals, **characterized in that** at least one metal foil (1) is provided, at the area of the edge perforations (2, 22, 42), with at least one opening (10) which extends each time between two successive edge perforations (2, 22, 42) but does not contact the edge perforations (2, 22, 42).

4. A foil as claimed in claim 3, **characterized in that** both metal foils (1, 20) are provided, in corresponding locations at the area of the edge perforations (2, 22, 42), with openings (10) which extend between each time two successive edge perforations (2, 22, 42) but do not contact the edge perforations (2, 22, 42).

## Revendications

1. Feuille sous la forme d'une bande de film étirée (1, 20, 40) avec des perforations marginales et des pistes conductrices comme substrat de divers circuits intégrés pour leur intégration, de préférence dans des cartes à puce, les pistes conductrices étant matricées à partir d'une feuille métallique (1 ; 20) et collées sur une feuille en plastique (40) dotée de perforations ou d'orifices traversants,
**caractérisée en ce que**, de part et d'autre de la feuille en plastique (40), une feuille métallique (1, 20) est respectivement collée avec différents modèles de piste conductrice et que les feuilles métalliques (1 ; 20) présentent de part et d'autre d'autres interruptions (3, 8, 10, 23, 24, 25, 26, 27, 28), en plus des interruptions ménagées par le modèle de piste conductrice préalablement déterminé pour la fabrication de liaisons conductrices, pour réduire, en direction longitudinale de la bande de feuille à intervalles courts par rapport à l'extension du modèle de piste conductrice, la section totale des deux feuilles métalliques (1, 20) perpendiculairement à la direction originale de la bande de film dans une mesure essentielle pour sa flexibilité.

2. Feuille selon la revendication 1 dans laquelle la feuille en plastique (40) présente à intervalles réguliers une perforation marginale (42) **caractérisée en ce qu'**une ouverture (3, 23) s'étendant sur plusieurs perforations marginales (42) successives est présente dans les deux feuilles métalliques (1, 20) à des endroits correspondants dans la région des perforations marginales (42).

3. Feuille selon la revendication 1, dans laquelle la feuille en plastique (40) présente à intervalles réguliers des perforations marginales (2, 22, 42), **caractérisée en ce que**, dans au moins une feuille métallique (1) dans la région des perforations marginales (2, 22, 42), au moins une ouverture (10) ne touchant pas les perforations marginales (2, 22, 42) et s'étendant entre eux deux perforations marginales successives (2, 22, 42) est présente.

4. Feuille selon la revendication 3, **caractérisée en ce que** des ouvertures (10) ne touchant pas les perforations marginales (2, 22, 42) et s'étendant entre deux perforations marginales successives (2, 22, 42) sont présentes dans les deux feuilles métalliques (1, 20) à des endroits correspondants dans la région des perforations marginales (2, 22, 42).
